# FASCICULE DE BREVET EUROPEEN

(11) **EP 2 955 717 B1**
(45) Date de publication et mention de la délivrance du brevet: **26.07.2023**
(21) Numéro de dépôt: 15171196.7
(22) Date de dépôt: 09.06.2015
(51) Int. Cl.: G11C 13/00

(54) **DISPOSITIF DE MEMOIRE VIVE RESISTIVE**
RESISTIVE ARBEITSSPEICHERVORRICHTUNG
RESISTIVE RANDOM ACCESS MEMORY DEVICE

(30) Priorité: 11.06.2014 FR 1455286
(43) Date de publication de la demande: 16.12.2015
(73) Titulaire: COMMISSARIAT À L'ÉNERGIE ATOMIQUE ET AUX ÉNERGIES ALTERNATIVES, 75015 Paris (FR); Altis Semiconductor, 75008 Paris (FR)
(72) Inventeur: MOLAS, Gabriel, 38000 GRENOBLE (FR); BLAISE, Philippe, 38000 GRENOBLE (FR); DAHMANI, Faiz, 94210 LA VARENNE SAINT-HILAIRE (FR); VIANELLO, Elisa, 38000 GRENOBLE (FR)
(74) Mandataire: Cabinet Camus Lebkiri

(56) Documents cités:
- FR-A1- 3 003 401
- US-A1- 2007 120 124
- US-A1- 2014 103 284
- CHEN Y Y ET AL: "Tailoring switching and endurance / retention reliability characteristics of HfO2 / Hf RRAM with Ti, Al, Si dopants", ENERGY EFFCIENCY CONVENTION (SAEEC), 2012 SOUTHERN AFRICAN, IEEE, 9 juin 2014 (2014-06-09), pages 1-2, XP032640150, ISSN: 0743-1562, DOI: 10.1109/VLSIT.2014.6894403 ISBN: 978-1-4673-5226-0 [extrait le 2014-09-08]
- ZHAO LIANG ET AL: "Dopant selection rules for extrinsic tunability of HfOx RRAM characteristics: A systematic study", ENERGY EFFCIENCY CONVENTION (SAEEC), 2012 SOUTHERN AFRICAN, IEEE, 11 juin 2013 (2013-06-11), XP032473751, ISSN: 0743-1562 ISBN: 978-1-4673-5226-0 [extrait le 2013-08-07]
- LIU L F ET AL: "Unipolar resistive switching and mechanism in Gd-doped-TiO2-based resistive switching memory devices;Unipolar RS and mechanism in Gd-doped-TiO_2-based RS memory devices", SEMICONDUCTOR SCIENCE AND TECHNOLOGY, IOP PUBLISHING LTD, GB, vol. 26, no. 11, 19 octobre 2011 (2011-10-19), page 115009, XP020213004, ISSN: 0268-1242, DOI: 10.1088/0268-1242/26/11/115009
- CHEN Y S ET AL: "Well controlled multiple resistive switching states in the Al local doped HfOresistive random access memory device", JOURNAL OF APPLIED PHYSICS, AMERICAN INSTITUTE OF PHYSICS, US, vol. 113, no. 16, 28 avril 2013 (2013-04-28), pages 164507-164507, XP012173555, ISSN: 0021-8979, DOI: 10.1063/1.4803076 [extrait le 2013-04-30]

## Description

### DOMAINE TECHNIQUE DE L'INVENTION

La présente invention concerne le domaine des mémoires réinscriptibles non volatiles, et plus spécifiquement celui des mémoires vives résistives de type CBRAM ou «Conductive Bridging RAM». Une mémoire vive résistive comprend des première et seconde électrodes séparées par une couche en matériau électriquement isolant, et passe d'un état isolant à un état conducteur par formation d'un filament conducteur entre les première et seconde électrodes.

### ARRIERE-PLAN TECHNOLOGIQUE DE L'INVENTION

Les mémoires vives à résistance variable (appelées mémoires RRAM pour « Resistive Random Access Memories » en anglais) sont aujourd'hui le sujet d'une grande attention, en raison notamment de leur faible consommation électrique et leur vitesse de fonctionnement élevée.

Une cellule mémoire de type résistive présente au moins deux états : un état fortement résistif « HRS » (« High Résistance State »), appelé également état « OFF », et un état faiblement résistif « LRS » (« Low Résistance State ») ou état « ON ». Elle peut donc être utilisée pour stocker une information binaire.

On peut distinguer trois types de mémoires résistives : les mémoires à base de mécanisme thermochimique, les mémoires à base de changement de valence, et les mémoires à base de métallisation électrochimique.

Le domaine de la présente invention concerne plus particulièrement cette dernière catégorie basée sur des matériaux à conduction ionique (mémoires CBRAM ou « Conductive Bridging RAM »). Le fonctionnement réside dans la formation et la rupture réversibles d'un filament conducteur dans un électrolyte solide, par dissolution d'une électrode soluble. Ces mémoires sont prometteuses de par leur faibles tensions de programmation (de l'ordre du Volt), leur temps de programmation court (<1 µs), leur faible consommation et leur faible coût d'intégration. De plus, ces mémoires peuvent être intégrées dans les niveaux de métallisation de la logique d'un circuit (« above IC »), ce qui permet d'augmenter la densité d'intégration du circuit. Du point de vue de l'architecture, elles requièrent seulement un dispositif de sélection, un transistor ou une diode par exemple.

Le fonctionnement des mémoires CBRAM est basé sur la formation, au sein d'un électrolyte solide, d'un ou plusieurs filaments métalliques (appelés également « dendrites ») entre deux électrodes, lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament.

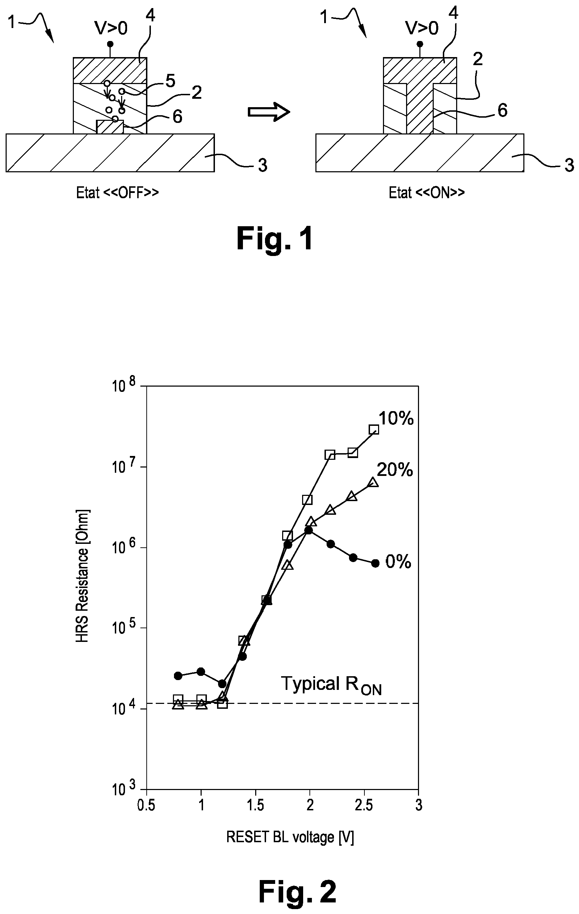

Les figures 1A et 1B sont des schémas de principe d'un dispositif mémoire 1 de type CBRAM, respectivement à l'état « OFF » et à l'état « ON ».

Ce dispositif 1 est formé par un empilement de type Métal/Conducteur ionique/Métal. Il comporte un électrolyte solide 2, par exemple à base de chalcogénure dopé (ex. GeS) ou d'oxyde (ex. Al₂O₃). L'électrolyte 2 est disposé entre une électrode inférieure 3, par exemple en Pt, formant une cathode inerte, et une électrode supérieure 4 comportant une portion de métal ionisable, par exemple du cuivre, et formant une anode. Une portion de métal ionisable est une portion de métal pouvant former des ions métalliques (ici des ions Cu²⁺), lorsqu'elle est soumise à un potentiel électrique approprié. Le dispositif 1 représenté sur la figure 1A ou 1B forme typiquement un point mémoire, c'est-à-dire une cellule mémoire unitaire, d'une mémoire comportant une multitude de ces dispositifs mémoires.

Comme indiqué précédemment, l'état mémoire d'un dispositif mémoire CBRAM résulte de la différence de résistivité électrique entre deux états : « ON » et « OFF ».

A l'état « OFF » (Fig.1A), les ions métalliques (ici les ions Cu²⁺ pour une électrode soluble comprenant du Cu) issus de la portion de métal ionisable sont dispersés dans tout l'électrolyte solide 2. Ainsi, aucun contact électrique n'est établi entre la cathode 3 et l'anode 4, c'est-à-dire entre l'électrode supérieure et l'électrode inférieure. L'électrolyte solide comporte une zone électriquement isolante de grande résistivité entre l'anode et la cathode.

Lorsqu'un potentiel V positif est appliqué sur l'électrode soluble supérieure 4 (l'anode), une réaction d'oxydo-réduction a lieu à cette électrode, créant des ions mobiles 5 (Fig.1A). Dans le cas d'une électrode 4 de cuivre, la réaction suivante a lieu :

Cu → Cu²⁺ + 2 e⁻.

Les ions 5 se déplacent alors dans l'électrolyte 2 sous l'effet du champ électrique appliqué aux électrodes. La vitesse de déplacement dépend de la mobilité de l'ion dans l'électrolyte en question, ce qui guide le choix du couple électrode soluble/électrolyte (exemples : Ag/GeS ; Cu/Al₂O₃...). Les vitesses de déplacement des ions sont de l'ordre du nm/ns.

Arrivés à l'électrode inerte 3 (la cathode), les ions 5 sont réduits de par la présence d'électrons fournis par l'électrode 3, entraînant la croissance d'un filament métallique 6 selon la réaction suivante :

Cu²⁺ + 2 e⁻ → Cu

Le filament 6 croît préférentiellement dans la direction de l'électrode soluble 4.

La mémoire 1 passe alors dans l'état « ON » (Fig.1B) lorsque le filament 6 permet le contact entre les électrodes 3 et 4, rendant l'empilement conducteur. Cette phase est appelée « SET » de la mémoire.

Pour passer à l'état « OFF » (phase de « RESET » de la mémoire), une tension V négative est appliquée sur l'électrode supérieure 4, entraînant la dissolution du filament conducteur. Pour justifier cette dissolution, des mécanismes thermiques (échauffement) et d'oxydoréduction sont généralement invoqués. Plus précisément, l'étape consistant à écrire pour la première fois la mémoire 1, c'est-à-dire à former pour la première fois le filament 6 dans l'électrolyte 2 de la mémoire 1, est appelée « forming ». On entend donc par « SET » l'étape de formation du filament 6 réalisée après au moins un premier effacement de la cellule mémoire, c'est-à-dire après que le filament de la cellule mémoire a au moins été formé une première fois (étape de forming) puis dissous (étape de RESET).

Souvent, l'électrolyte 2 contient dans l'état « OFF » un filament résiduel 6 en contact avec la cathode 3. Celui-ci provient de la phase de SET précédente et n'a pas été dissous complètement lors du RESET de la mémoire. Le filament est dit résiduel lorsqu'il n'établit pas une conduction électrique suffisante entre les électrodes pour obtenir l'état « ON ».

Une voie de développement pour les mémoires CBRAM concerne l'élargissement de la fenêtre mémoire ; cette dernière est définie par le ratio entre les résistances des états isolants « OFF » et passant « ON », c'est-à-dire le ratio Roff/Ron. Plus ce ratio est élevé, plus il est facile de distinguer les deux états logiques « OFF » et « ON » de la mémoire CBRAM. Une large fenêtre permet même d'envisager du codage multi-bit, c'est-à-dire d'obtenir plus de deux états avec une cellule mémoire unique en utilisant plusieurs niveaux (i.e. au moins 3) de résistance.

Le document de l'état de la technique US2007/120124 A1 décrit une cellule mémoire résistive à base d'oxyde métallique ne comportant pas une électrode configurée à fournir des ions mobiles circulant dans un électrolyte solide vers une autre électrode pour former un filament conducteur entre les première et deuxième électrodes lorsqu'une tension est appliqueé entre les première et deuxième électrodes. Les documents de l'état de la technique CHEN ET AL: "Tailoring switching and endurance/retention reliability characteristics of HfO2/Hf RRAM with Ti, Al, Si dopants", IEEE, 9 juin 2014, XP032640150, ISSN: 0743-1562, DOI: 10.1109/VLSIT.2014.6894403, ISBN: 978-1-4673-5226-0 et ZHAO LIANG ET AL: "Dopant sélection rules for extrinsic tunability of HfOx RRAM characteristics: a systematic study", IEEE, 11 juin 2013, XP032473751, ISSN: 0743-1562, ISBN: 978-1-4673-5226-0 décrivent des cellules mémoires résistives de type OxRRAM à base d'oxyde métallique avec des électrodes inertes.

### RESUME DE L'INVENTION

L'invention vise à apporter une solution aux problèmes évoqués précédemment en proposant une cellule mémoire CBRAM à base d'oxyde métallique selon la revendication 1 aux performances électriques améliorées, et en particulier avec une fenêtre mémoire élevée.

Un premier aspect de l'invention concerne donc une cellule mémoire vive résistive basée sur des matériaux à conduction ionique selon la revendication 1.

On entend par « énergie de bande interdite », ou « gap », d'un matériau, la largeur de la bande interdite dudit matériau, c'est-à-dire la différence d'énergie entre le minimum de la bande de conduction et le maximum de la bande de valence.

L'invention permet avantageusement de contribuer à l'augmentation de la fenêtre mémoire en utilisant un dopage de l'électrolyte en oxyde métallique MOx (par exemple un oxyde gadolinium GdOx, avec une composition pouvant être Gd₂O₃) par un deuxième élément (préférentiellement métallique) D (par exemple de l'aluminium AI) choisi de sorte que l'énergie de bande interdite de l'oxyde DOx soit strictement supérieure à l'énergie de bande interdite de l'oxyde MOx. Pour atteindre ce résultat, le pourcentage atomique du deuxième élément D au sein de la région de l'électrolyte solide dopée est compris entre 5% et 20%.

Grâce à l'invention, cet élargissement de la fenêtre mémoire ne se fait par ailleurs pas au détriment d'autres performances électriques de la mémoire telles que la tension de forming ou la rétention.

Ainsi, une des difficultés des mémoires CBRAM à base d'oxyde métallique concerne la difficulté de former le filament dans l'électrolyte lors de la première utilisation de la mémoire, c'est-à-dire lors de l'étape de forming. Cette étape consiste à appliquer une tension aux bornes de la mémoire, dite « tension de forming », nécessaire à la formation du filament dans l'électrolyte lors de la première utilisation de la cellule mémoire CBRAM. Le dopage par le deuxième métal D tel que l'aluminium peut avoir deux effets opposés ; ce dopage permet d'une part de contribuer à la création d'une pluralité de lacunes d'oxygène dans l'électrolyte, et particulièrement dans la région de l'électrolyte en premier oxyde métallique dopé par le deuxième métal D. Cette pluralité de lacunes d'oxygène permet de faciliter le déplacement des ions mobiles, et donc la formation du filament conducteur. On contribue ainsi à diminuer la tension de forming, c'est-à-dire la tension à appliquer entre l'électrode soluble et l'électrode inerte pour permettre la formation du filament conducteur lors de l'étape de forming. A l'inverse, en dopant trop l'électrolyte, on prend le risque de se rapprocher d'un alliage (par exemple un alliage Gd_{2-y}Al_{y}O₃) ; dans ce cas, en remplaçant l'électrolyte par un alliage ternaire, on s'éloigne des propriétés du Gd₂O₃ pour se rapprocher de celles de l'Al₂O₃ et la tension de forming sera augmentée dans la mesure où l'Al₂O₃ présente une tension de forming intrinsèquement (i.e. toutes les caractéristiques technologiques telles que la méthode de dépôt du Gd₂O₃ et de l'Al₂O₃ étant les mêmes par ailleurs) plus élevée que celle du Gd₂O₃. Afin de conserver une tension de forming réduite (ou au moins de conserver une tension de forming proche de celle du matériau de l'électrolyte non dopé, par exemple Gd₂O₃), il convient de choisir le pourcentage atomique ad hoc pour le deuxième métal D au sein de la région de l'électrolyte solide dopée ; un pourcentage compris entre 5% et 20% permet de répondre efficacement à ces deux effets opposés.

Une autre difficulté des mémoires CBRAM à base d'oxyde métallique concerne la rétention de l'information, c'est-à-dire la rétention de l'état « OFF » et de l'état « ON ». On cherche à améliorer la stabilité des états isolant et conducteur, notamment pour des températures de fonctionnement élevées.

On considère qu'il y a une faute en rétention lorsque la cellule mémoire perd l'information, cette perte étant définie à partir d'un critère prédéterminé ; par exemple, à l'état initial (t=0), c'est-à-dire immédiatement après avoir appliqué l'opération d'écriture, la résistance R_{ON} de la mémoire à l'état « ON » est minimale. Puis, au fil du temps, la résistance à l'état « ON » augmente. Le critère prédéterminé consiste par exemple à définir un seuil de résistance au-delà duquel on considère que la rétention de l'information n'est plus assurée. A partir de ce seuil, on considère que la mémoire est dans un état d'échec. On pourra par exemple considérer que l'information dans la cellule mémoire est perdue lorsque sa résistance a augmenté d'un facteur 2 par rapport à sa résistance initiale R_{ON} juste après programmation (t=0). Comme évoqué plus haut, le dopage par le deuxième métal D contribue à la création d'une pluralité de lacunes d'oxygène dans l'électrolyte ; l'introduction de lacunes d'oxygène dans l'électrolyte a pour conséquence de dégrader la rétention ; en effet les lacunes d'oxygène offrent des sites de diffusion privilégiés pour les atomes (par exemple de Cu) constituant le filament. La dissolution du filament est donc accélérée. Il faut donc introduire suffisamment peu de dopants pour ne pas dégrader la rétention ; un pourcentage compris entre 5% et 20% permet de limiter cette dégradation, voire de maintenir une rétention sensiblement identique à celle obtenue avec le matériau de l'électrolyte non dopé.

Outre les caractéristiques qui viennent d'être évoquées dans le paragraphe précédent, le dispositif selon un aspect de l'invention peut présenter une ou plusieurs caractéristiques complémentaires parmi les suivantes, considérées individuellement ou selon toutes les combinaisons techniquement possibles :
- le deuxième élément est choisi de sorte que la permittivité électrique du matériau de la région dopée soit inférieure ou égale que la permittivité électrique du premier oxyde métallique ; ainsi, la permittivité du Gd₂O₃ :Al (Gd₂O₃ dopé avec de l'AI) est inférieure à la permittivité du Gd₂O₃ non dopé ;
- le deuxième élément est choisi de sorte que la permittivité électrique du deuxième oxyde soit strictement inférieure à la permittivité électrique du premier oxyde métallique ; ce mode de réalisation couvre le cas où le deuxième élément crée localement un matériau (par exemple un matériau du type AIOx dans le cas du dopage par de l'AI) dans le premier oxyde (par exemple le Gd₂O₃), c'est-à-dire le cas où le matériau n'est pas totalement inter-mixé après le dopage ;
- le deuxième élément est un métal distinct du premier métal et apte à former un deuxième oxyde métallique ;
- ledit deuxième élément est choisi de sorte que le premier oxyde métallique dopé par le deuxième élément présente une énergie de bande interdite sensiblement égale à l'énergie de bande interdite du premier oxyde métallique non dopé par le deuxième élément ; on entend par deux énergies sensiblement égales deux énergies égales à +/- 200 meV ;
- le pourcentage atomique du deuxième élément au sein de la région de l'électrolyte solide est sensiblement égal à 10% ;
- le premier oxyde métallique est de l'oxyde de gadolinium et le deuxième élément est de l'aluminium ;
- selon une première variante, l'électrolyte solide comporte :
   o une première sous-couche en contact avec la première électrode en matériau inerte, et
   o une deuxième sous-couche en contact avec la deuxième électrode en matériau soluble, la région de l'électrolyte solide en premier oxyde métallique dopé par le deuxième élément étant une sous-couche centrale comprise entre les première et deuxième sous-couches ;
- selon une deuxième variante, l'électrolyte solide comporte :
   o une première sous-couche en contact avec la première électrode en matériau inerte, et
   o une deuxième sous-couche en contact avec la deuxième électrode en matériau soluble,
   o une sous-couche centrale comprise entre les première et deuxième sous-couches ;
la région de l'électrolyte solide en premier oxyde métallique dopé par le deuxième élément étant la première sous-couche et/ou la deuxième sous-couche ;
- selon une troisième variante, l'électrolyte solide est entièrement formé par la région en premier oxyde métallique dopé par le deuxième élément ;
- ledit deuxième élément est choisi de sorte que la longueur de la liaison entre le deuxième élément et l'oxygène est inférieure à la longueur de la liaison entre le premier métal et l'oxygène.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 illustre schématiquement le passage d'un état « OFF » à un état « ON » pour un dispositif mémoire de type CBRAM ;
- la figure 2 illustre l'évolution de la résistance « OFF » d'une cellule mémoire CBRAM pour différents pourcentages atomiques de deuxième métal dopant au sein de la région de l'électrolyte solide ;
- la figure 3 montre schématiquement la structure d'une cellule mémoire CBRAM à base d'oxyde selon un mode de réalisation de l'invention ;
- la figure 4 montre schématiquement la structure d'une cellule mémoire CBRAM à base d'oxyde selon une variante du mode de réalisation de l'invention de la figure 3.

### DESCRIPTION DETAILLEE D'AU MOINS UN MODE DE REALISATION DE L'INVENTION

Sauf précision contraire, un même élément apparaissant sur des figures différentes présente une référence unique.

Dans la présente description, on entend par « cellule mémoire CBRAM à base d'oxyde » une cellule mémoire CBRAM comportant un électrolyte réalisé à base d'un oxyde métallique.

Comme mentionné plus haut, l'invention permet avantageusement de contribuer à l'augmentation de la fenêtre mémoire en utilisant un dopage de l'électrolyte en oxyde métallique MOx (par exemple un oxyde gadolinium GdOx tel que Gd₂O₃) par un deuxième élément (préférentiellement métallique, par exemple de l'aluminium AI) choisi de sorte que l'énergie de bande interdite de l'oxyde DOx soit strictement supérieure à l'énergie de bande interdite de l'oxyde MOx. Pour atteindre ce résultat, le pourcentage atomique du deuxième élément D au sein de la région de l'électrolyte solide dopée est compris entre 5% et 20%.

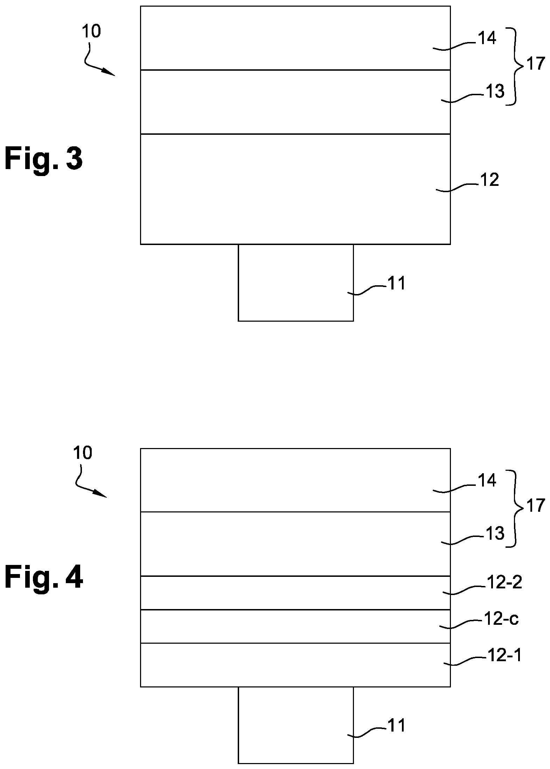

Un exemple d'une cellule mémoire CBRAM 10 conforme à l'invention est illustré en figure 3.

La cellule mémoire 10 comporte :
- une première électrode 11, également appelée cathode ou électrode inerte par la suite ;
- un électrolyte solide 12. L'électrolyte solide 12 comporte une région en oxyde d'un premier métal, dit « premier oxyde métallique », ladite région étant dopée par un deuxième métal, distinct du premier métal et apte à former un deuxième oxyde métallique. Le deuxième métal est choisi de sorte que l'énergie de bande interdite du deuxième oxyde métallique est strictement supérieure à l'énergie de bande interdite du premier oxyde métallique et le pourcentage atomique du deuxième métal au sein de la région de l'électrolyte solide 12 est compris entre 5% et 20% ;
- une deuxième électrode 17, également appelée anode ou électrode soluble par la suite, et comportant une couche de source d'ions 13 et une ligne métallique 14.

Lorsqu'une tension est appliquée entre l'électrode inerte 11 et la ligne métallique 14 de l'électrode soluble 17, la couche de source d'ions 13 fournit des ions mobiles 15 qui circulent dans l'électrolyte solide 12 vers l'électrode inerte 11 pour former un filament conducteur entre l'électrode inerte 11 et l'électrode soluble 17..

Selon le premier mode de réalisation illustré à la figure 3, l'électrode inerte 11 est un plot, par exemple réalisé à partir d'un métal inerte d'interconnexion, tel que du tungstène W, du nitrure de titane TiN ou du nitrure de tantale TaN.

Selon le premier mode de réalisation illustré à la figure 3, la couche de source d'ions 13 de l'électrode soluble 17 est réalisée à partir d'un alliage de cuivre Cu et d'un élément de la famille des chalcogènes tel que du Te. La couche de source d'ions 13 de l'électrode soluble 17 peut donc être réalisée à partir de CuTe. Plus généralement, la couche de source d'ions 13 peut être réalisée à partir de cuivre Cu et de ses alliages, d'argent Ag et de ses alliages, de zinc Zn et de ses alliages, d'un alliage de cuivre et/ou de zinc et/ou d'argent, tel que : AgCu, AgZn, CuZn, AgCuZn, et de ses alliages.

Selon un mode de réalisation particulièrement avantageux illustré à la figure 3, l'électrolyte solide 12 est réalisé en oxyde de gadolinium Gd₂O₃ et le deuxième métal dopant est de l'aluminium Al avec un pourcentage atomique choisi pour que le premier oxyde métallique dopé par le deuxième métal (i.e. le Gd₂O₃:Al) présente une énergie de bande interdite sensiblement égale à l'énergie de bande interdite du premier oxyde métallique non dopé (i.e. le Gd₂O₃) à 200 meV près. Un pourcentage atomique d'AI sensiblement égal à 10% répond avantageusement à cette dernière contrainte et permet d'obtenir l'effet recherché sur la fenêtre mémoire sans dégrader la tension de forming et la rétention.

L'effet de l'introduction de métal dopant dans l'électrolyte sur la fenêtre mémoire est notamment illustré en figure 2 qui représente l'évolution de la valeur de la résistance R_{OFF} à l'état « OFF » en fonction de la tension d'effacement (i.e. la tension de RESET). Trois courbes (i.e. trois évolutions de résistance) sont représentées pour trois niveaux de dopage :
- pourcentage atomique de 20% d'AI dans l'électrolyte en Gd₂O₃ ;
- pourcentage atomique de 10% d'AI dans l'électrolyte en Gd₂O₃ ;
- pourcentage atomique de 0% d'AI (i.e. échantillon de référence non dopé) dans l'électrolyte en Gd₂O₃ ;

La figure 2 représente également schématiquement la valeur de la résistance à l'état « ON » ; on notera que cette résistance R_{ON} ne varie quasiment pas une fois le seuil de la tension de SET dépassé ; le pourcentage atomique d'AI dans l'électrolyte a également peu d'effet sur la valeur de R_{ON} qui reste sensiblement constante à 10⁴ Ohms. A l'inverse, on observe que la valeur R_{OFF} est beaucoup plus dépendante de la technologie utilisée. Plus on augmente la tension de RESET plus la valeur de R_{OFF} augmente et en conséquence, plus la fenêtre mémoire est élevée.

L'invention repose sur le constat que le comportement de la résistance R_{OFF} en fonction de la tension de RESET n'est pas le même selon le pourcentage atomique de dopant dans l'électrolyte. On observe tout d'abord que la résistance R_{OFF} est plus élevée lorsque l'électrolyte est effectivement dopé par un deuxième métal (i.e. par rapport à l'échantillon de référence non dopé) ; ce phénomène peut s'expliquer par le fait que l'on ait choisi un élément métallique de dopage dont l'oxyde métallique associé (ici l'Al₂O₃) présente une fenêtre plus élevée que celle du matériau de l'électrolyte (i.e. le Gd₂O₃). Au-delà de cette première constatation liée au dopage, le demandeur a également observé que le pourcentage atomique de dopage a également un effet sur la valeur de la fenêtre mémoire. Ainsi, un niveau de dopage de 10% permet d'obtenir une fenêtre mémoire plus large qu'un niveau de dopage de 20%.

Une fois observé cet effet particulièrement avantageux sur la fenêtre mémoire, il convient également de s'assurer que le dopage ne va pas dégrader d'autres caractéristiques électrique de la mémoire, notamment la tension de forming et la rétention. Pour ce faire, la mémoire selon l'invention présente un pourcentage atomique de dopant métallique optimisé comprise entre 5 et 20%, étant entendu qu'un pourcentage sensiblement égal à 10% représente un mode de réalisation particulièrement avantageux (amélioration sensible de la fenêtre mémoire sans dégradation de la tension de forming et de la rétention).

S'agissant de la rétention, selon un mode de réalisation avantageux, le dopant métallique peut être choisi pour que la liaison entre le dopant D (à titre illustratif l'AI) et l'oxygène (liaison D-O) soit plus petite que celle de Gd-O : un tel choix permet de conserver voir d'améliorer la rétention. En l'espèce, la liaison AI-O présente une longueur de 1.8A alors que la liaison Gd-O présente une longueur de 2.2A.

L'exemple préférentiel du Gd₂O₃ dopé par 10% d'AI n'est pas limitatif ; plusieurs variantes sont possibles pour le couple formé par le matériau d'électrolyte et le dopant, parmi lesquelles :
- un oxyde de gadolinium Gd₂O₃ dopé par exemple par du Si (ici le deuxième élément dopant n'est pas métallique mais semiconducteur), du Be, du B, du Mg, du Ca ou du Sr ;
- un oxyde d'aluminium Al2O3 dopé par du Si ;
- un oxyde d'hafnium HfO2 dopé par de l'Al ou du Si
- un oxyde de zirconium ZrO2 dopé par de l'Hf, du Gd, de l'Al ou du Si ;
- un oxyde de titane TiO2 dopé par du Zr, de l'Hf, du Gd, de l'Al ou du Si.

La région dopée de l'électrolyte solide 12 peut par exemple être réalisée en effectuant une copulvérisation d'une cible de premier oxyde métallique et d'une cible de deuxième métal. Il est notamment possible de mesurer le pourcentage atomique du deuxième métal dopant au sein de la région dopée de l'électrolyte solide 12 par une technique de spectroscopie de rétrodiffusion de Rutherford RBS (de l'anglais « Rutherford Backscattering Spectroscopy »).

La figure 4 illustre une deuxième variante d'une cellule mémoire 10 selon l'invention dans laquelle la région dopée de l'électrolyte solide 12 est une sous-couche centrale 12-c de l'électrolyte solide 12, le pourcentage atomique de l'aluminium Al dans la sous-couche centrale 12-c étant sensiblement égal à 10%. La sous-couche centrale 12-c de l'électrolyte solide 12 est comprise entre des première et deuxième sous-couches 12-1 et 12-2 de l'électrolyte solide 12, la première sous-couche 12-1 étant en contact avec l'électrode inerte 11, et la deuxième sous-couche 12-2 étant en contact avec la couche de source d'ions 13.

L'étendue de la protection de la présente invention est définie par les revendications 1 à 11 annexées.

## Revendications

1. Cellule mémoire (10) vive résistive basée sur des matériaux à conduction ionique de type CBRAM, «Conductive Bridging RAM», à base d'oxyde métallique comportant:
- une première électrode (11) en matériau inerte ;
- une deuxième électrode (17) en matériau soluble ;
- un électrolyte solide (12), les première et deuxième électrodes (11, 17) étant respectivement en contact avec l'une des faces de l'électrolyte (12) de part et d'autre dudit électrolyte, la deuxième électrode (17) étant configurée à fournir des ions mobiles (15) circulant dans l'électrolyte solide (12) vers la première électrode (11) pour former un filament conducteur entre les première et deuxième électrodes lorsqu'une tension est appliquée entre les première et deuxième électrodes ;
ledit dispositif (10) étant réalisé en ce que l'électrolyte solide (12) comporte une région réalisée en un oxyde d'un premier élément métallique, dit « premier oxyde métallique » et en ce que ladite région est dopée par un deuxième élément, distinct du premier métal et configurée à former un deuxième oxyde, ledit deuxième élément étant choisi de sorte que l'énergie de bande interdite du deuxième oxyde est strictement supérieure à l'énergie de bande interdite du premier oxyde métallique, le pourcentage atomique du deuxième élément au sein de la région de l'électrolyte solide (12) étant compris entre 5% et 20%.

2. Cellule mémoire selon la revendication 1 d'après laquelle le deuxième élément est choisi de sorte que la permittivité électrique du matériau de la région dopée soit inférieure ou égale à la permittivité électrique du premier oxyde métallique.

3. Cellule mémoire selon la revendication 1 d'après laquelle le deuxième élément est choisi de sorte que la permittivité électrique du deuxième oxyde soit strictement inférieure à la permittivité électrique du premier oxyde métallique.

4. Cellule mémoire selon l'une des revendications précédentes d'après laquelle le deuxième élément est un métal distinct du premier métal et apte à former un deuxième oxyde métallique.

5. Cellule mémoire selon l'une des revendications précédentes d'après laquelle ledit deuxième élément est choisi de sorte que le premier oxyde métallique dopé par le deuxième élément présente une énergie de bande interdite sensiblement égale à l'énergie de bande interdite du premier oxyde métallique non dopé par le deuxième élément.

6. Cellule mémoire selon l'une des revendications précédentes d'après laquelle le pourcentage atomique du deuxième élément au sein de la région de l'électrolyte solide (12) est sensiblement égal à 10%.

7. Cellule mémoire selon l'une des revendications précédentes d'après laquelle le premier oxyde métallique est de l'oxyde de gadolinium et en ce que le deuxième élément est de l'aluminium.

8. Cellule mémoire selon l'une des revendications précédentes d'après laquelle l'électrolyte solide (12) comporte :
- une première sous-couche (12-1) en contact avec la première électrode (11) en matériau inerte, et
- une deuxième sous-couche (12-2) en contact avec la deuxième électrode (17) en matériau soluble ;
la région de l'électrolyte solide (12) en premier oxyde métallique dopé par le deuxième élément étant une sous-couche centrale (12-c) comprise entre les première et deuxième sous-couches (12-1, 12-2).

9. Cellule mémoire selon l'une des revendications précédentes d'après laquelle l'électrolyte solide comporte :
- une première sous-couche en contact avec la première électrode en matériau inerte, et
- une deuxième sous-couche en contact avec la deuxième électrode en matériau soluble ;
- une sous-couche centrale comprise entre les première et deuxième sous-couches ;
la région de l'électrolyte solide en premier oxyde métallique dopé par le deuxième élément étant la première sous-couche et/ou la deuxième sous-couche.

10. Cellule mémoire selon l'une des revendications 1 à 7 d'après laquelle l'électrolyte solide (12) est entièrement formé par la région en premier oxyde métallique dopé par le deuxième élément.

11. Cellule mémoire selon l'une des revendications précédentes d'après laquelle ledit deuxième élément est choisi de sorte que la longueur de la liaison entre le deuxième élément et l'oxygène est inférieure à la longueur de la liaison entre le premier élément métallique et l'oxygène.

## Patentansprüche

1. Resistive RAM-Speicherzelle (10) auf der Basis von ionenleitenden Materialien vom Typ CBRAM, "Conductive Bridging RAM", auf der Basis von Metalloxid, die Folgendes umfasst:
- eine erste Elektrode (11) aus inertem Material;
- eine zweite Elektrode (17) aus löslichem Material;
- einen festen Elektrolyten (12), wobei die erste und die zweite Elektrode (11, 17) jeweils mit einer der Seiten des Elektrolyten (12) auf beiden Seiten des Elektrolyten in Kontakt stehen, wobei die zweite Elektrode (17) so gestaltet ist, dass sie die beweglichen Ionen (15), die in dem festen Elektrolyten (12) zirkulieren, der ersten Elektrode (11) zuführt, um einen leitenden Faden zwischen der ersten und der zweiten Elektrode zu bilden, wenn eine Spannung zwischen der ersten und der zweiten Elektrode angelegt wird;
wobei die Vorrichtung (10) dadurch realisiert wird, dass der feste Elektrolyt (12) einen Bereich umfasst, der aus einem Oxid eines ersten Metallelements, dem sogenannten "ersten Metalloxid", hergestellt ist, und dass dieser Bereich mit einem zweiten Element dotiert ist, das sich von dem ersten Metall unterscheidet und so gestaltet ist, dass es ein zweites Oxid bildet, wobei das zweite Element so gewählt ist, dass die Bandlückenenergie des zweiten Oxids strikt größer ist als die Bandlückenenergie des ersten Metalloxids, wobei der atomare Anteil des zweiten Elements innerhalb des Bereichs des Festelektrolyten (12) zwischen 5 % und 20 % liegt.

2. Speicherzelle nach Anspruch 1, nach dem das zweite Element so ausgewählt ist, dass die elektrische Permittivität des Materials des dotierten Bereichs kleiner oder gleich der elektrischen Permittivität des ersten Metalloxids ist.

3. Speicherzelle nach Anspruch 1, nach dem das zweite Element so ausgewählt ist, dass die elektrische Permittivität des zweiten Oxids strikt kleiner als die elektrische Permittivität des ersten Metalloxids ist.

4. Speicherzelle nach einem der vorhergehenden Ansprüche, nach dem das zweite Element ein Metall ist, das sich von dem ersten Metall unterscheidet und in der Lage ist, ein zweites Metalloxid zu bilden.

5. Speicherzelle nach einem der vorhergehenden Ansprüche, nach dem das zweite Element so ausgewählt ist, dass das erste Metalloxid, das mit dem zweiten Element dotiert ist, eine Bandlückenenergie aufweist, die im Wesentlichen gleich der Bandlückenenergie des ersten Metalloxids ist, das nicht mit dem zweiten Element dotiert ist.

6. Speicherzelle nach einem der vorhergehenden Ansprüche, nach dem der atomare Anteil des zweiten Elements innerhalb des Bereichs des Festelektrolyten (12) im Wesentlichen gleich 10 % ist.

7. Speicherzelle nach einem der vorhergehenden Ansprüche, nach dem das erste Metalloxid Gadoliniumoxid ist und das zweite Element Aluminium ist.

8. Speicherzelle nach einem der vorhergehenden Ansprüche, nach dem der Festelektrolyt (12) Folgendes umfasst:
- eine erste Unterschicht (12-1), die mit der ersten Elektrode (11) aus inertem Material in Kontakt steht, und
- eine zweite Unterschicht (12-2), die mit der zweiten Elektrode (17) aus löslichem Material in Kontakt steht;
wobei der Bereich des Festelektrolyten (12) aus dem ersten Metalloxid, das mit dem zweiten Element dotiert ist, eine zentrale Unterschicht (12-c) bildet, die zwischen der ersten und der zweiten Unterschicht (12-1, 12-2) eingeschlossen ist.

9. Speicherzelle nach einem der vorhergehenden Ansprüche, nach dem der Festelektrolyt Folgendes umfasst:
- eine erste Unterschicht, die mit der ersten Elektrode aus inertem Material in Kontakt steht, und
- eine zweite Unterschicht, die mit der zweiten Elektrode aus löslichem Material in Kontakt steht;
- eine zentrale Unterschicht, die zwischen der ersten und der zweiten Unterschicht eingeschlossen ist;
wobei der Bereich des Festelektrolyten aus dem ersten Metalloxid, das mit dem zweiten Element dotiert ist, die erste Unterschicht und/oder die zweite Unterschicht bildet.

10. Speicherzelle nach einem der Ansprüche 1 bis 7, nach dem der Festelektrolyt (12) vollständig aus dem Bereich des ersten Metalloxids, das mit dem zweiten Element dotiert ist, gebildet wird.

11. Speicherzelle nach einem der vorhergehenden Ansprüche, nach dem das zweite Element so ausgewählt ist, dass die Länge der Verbindung zwischen dem zweiten Element und dem Sauerstoff geringer ist als die Länge der Verbindung zwischen dem ersten metallischen Element und dem Sauerstoff.

## Claims

1. Resistive random access memory cell (10) based on ionic conduction materials of the CBRAM, "Conductive Bridging RAM", type, based on metal oxide comprising:
- a first electrode (11) made of inert material;
- a second electrode (17) made of soluble material;
- a solid electrolyte (12), the first and second electrodes (11, 17) being respectively in contact with one of the faces of the electrolyte (12) on either side of said electrolyte, the second electrode (17) being configured to provide movable ions (15) circulating in the solid electrolyte (12) to the first electrode (11) to form a conductive filament between the first and second electrodes when a voltage is applied between the first and second electrodes;
said device (10) being made so that the solid electrolyte (12) comprises a region made of an oxide of a first metal element, called "first metal oxide" and in that said region is doped with a second element, distinct from the first metal and configured to form a second oxide, said second element being selected so that the band gap energy of the second oxide is strictly greater than the band gap energy of the first metal oxide, the atomic percent of the second element within the region of the solid electrolyte (12) being of between 5% and 20%.

2. Memory cell according to claim 1, wherein the second element is selected so that the electric permittivity of the material of the doped region is lower than or equal to the electric permittivity of the first metal oxide.

3. Memory cell according to claim 1, wherein the second element is selected so that the electric permittivity of the second oxide is strictly lower than the electric permittivity of the first metal oxide.

4. Memory cell according to one of the preceding claims, wherein the second element is a metal distinct from the first metal and capable of forming a second metal oxide.

5. Memory cell according to one of the preceding claims, wherein the second element is selected so that the first metal oxide doped with the second element has a band gap energy substantially equal to the band gap energy of the first metal oxide not doped with the second element.

6. Memory cell according to one of the preceding claims, wherein the atomic percent of the second element within the region of the solid electrolyte (12) is substantially equal to 10%.

7. Memory cell according to one of the preceding claims, wherein the first metal oxide is gadolinium oxide and the second element is aluminium.

8. Memory cell according to one of the preceding claims, wherein the solid electrolyte (12) comprises:
- a first sub-layer (12-1) in contact with the first electrode (11) made of inert material, and
- a second sub-layer (12-2) in contact with the second electrode (17) made of soluble material;
the region of the solid electrolyte (12) made of first metal oxide doped with the second element being a central sub-layer (12-c) comprised between the first and second sub-layers (12-1, 12-2).

9. Memory cell according to one of the preceding claims, wherein the solid electrolyte includes:
- a first sub-layer in contact with the first electrode made of inert material, and
- a second sub-layer in contact with the second electrode made of soluble material;
- a central sub-layer comprised between the first and second sub-layers;
the region of the solid electrolyte made of first metal oxide doped with the second element being the first sub-layer and/or the second sub-layer.

10. Memory cell according to one of claims 1 to 7, wherein the solid electrolyte (12) is entirely formed by the region made of first metal oxide doped with the second element.

11. Memory cell according to one of the preceding claims, wherein said second element is selected such that the length of the bond between the second element and oxygen is lower than the length of the bond between the first metal element and oxygen.
